# EUROPEAN PATENT SPECIFICATION

(11) **EP 0 590 870 B1**
(45) Date of publication and mention of the grant of the patent: **23.07.1997**
(21) Application number: 93307504.6
(22) Date of filing: 22.09.1993
(51) Int. Cl.: H01L 33/00, H01S 3/19, H01L 21/306, H01L 21/3065

(54) **Method of making a buried heterostructure laser**
Herstellungsverfahren für einen Halbleiterlaser mit vergrabener Heterostruktur
Méthode de fabrication d'un laser à hétérostructure enterré

(30) Priority: 30.09.1992 US 954648
(43) Date of publication of application: 06.04.1994
(73) Proprietor: AT&T Corp., New York, NY 10013-2412 (US)
(72) Inventor: Hayes, Todd Robert, Plainfield, New Jersey 07063 (US); Karlicek Jr., Robert Frank, Berkeley Heights, New Jersey 07922 (US); Lee, Byung-Teak, Scotch Plains, New Jersey 07076 (US); Logan, Ralph Andre, Morristown, New Jersey 07960 (US)
(74) Representative: Watts, Christopher Malcolm Kelway, Dr.

(56) References cited:
- GB-A- 2 253 304
- PATENT ABSTRACTS OF JAPAN vol. 12, no. 420 (E-679) 8 November 1988 & JP-A-63 158 888
- APPLIED PHYSICS LETTERS, vol.56, no.15, 9 April 1990, NEW YORK, US pages 1424 - 1426, XP149823 S.J. PEARTON ET AL. 'Electron Cyclotron Resonance Plasma Etching of InP in CH4/H2/Ar'
- PATENT ABSTRACTS OF JAPAN vol. 10, no. 279 (E-439) 20 September 1986 & JP-A-61 099 337
- APPLIED PHYSICS LETTERS, vol.55, no.16, 16 October 1989, NEW YORK, US pages 1633 - 1635, XP100009 S.J. PEARTON ET AL. 'Electrical and Structural Changes in the Near Surface of Reactively Ion Etched InP'
- JOURNAL OF CRYSTAL GROWTH, vol.109, no.1/4, February 1991, AMSTERDAM, NL pages 264 - 271, XP243703 J.L. ZILKO ET AL. 'Effect of Mesa Shape on the Planarity of InP Regrowths Performed by Atmospheric Pressure and Low Pressure Selective Metalorganic Vapor Phase Epitaxy'
- ELECTRONICS LETTERS, vol.28, no.5, 27 February 1992, STEVENAGE, GB pages 448 - 449, XP282109 S.J. PEARTON ET AL. 'New High-Rate Dry Etch Mixture for InP-Based Heterostructures'
- APPLIED SURFACE SCIENCE, vol.50, no.1-4, June 1991, NL pages 281 - 284 G.M. CREAN ET AL. 'Investigation of Reactive Ion Etch-Induced Damage in InP Surfaces Using a Noncontact Photothermal Radiometric Probe'
- JOURNAL OF VACUUM SCIENCE & TECHNOLOGY B, vol.9, no.3, May 1991, NEW YORK, US pages 1421 - 1432, XP367925 S.J. PEARSON ET AL. 'Comparison of CH4/H2/Ar Reactive Ion Etching and Electron Cyclotron Resonance Plasma Etching of In-Based III-V Alloys'
- APPLIED PHYSICS LETTERS, vol.61, no.5, 3 August 1992, NEW YORK, US pages 586 - 588 S.J. PEARSON ET AL. 'Damage Introduction in InP and InGaAs During Ar and H2 Plasma Exposure'
- PATENT ABSTRACTS OF JAPAN vol. 7, no. 62 (E-164) 15 March 1983 & JP-A-57 210 631
- JAPANESE JOURNAL OF APPLIED PHYSICS, vol.30, no.9A, September 1991, TOKYO, JP pages 2123 - 2126, XP263179 A. MATSUTANI ET AL. 'Reactive Ion Beam Etch of GaInAsP/InP Multilayer and Removal of Damaged Layer by Two-Step Etch'
- SUPERLATTICES AND MICROSTRUCTURES, vol.7, no.4, 1990, LONDON, GB pages 381 - 385, XP172224 C.D.W. WILKINSON 'Dry Etch Damage and its Effect on Electronic and Optical Nanostructures'

## Description

### Field of the Invention

This invention pertains to methods of making III/V buried heterostructure (BH) lasers.

### Background of the Invention

InP-based BH lasers can be designed to emit radiation of wavelength in either of the two wavelength regions of current interest for optical fiber communications, namely, about 1.3µm and about 1.55µm. Such lasers thus are of considerable commercial significance. For a description of such lasers see, for instance, H. Lipsanen et al., IEEE Photonic Technology Letters, Vol. 4(7), p. 673.

InP-based BH lasers are conventionally made by a process that comprises deposition of a SiO₂ mask stripe, wet etching such that a mesa remains under the mask stripe, followed by typically vapor phase epitaxial growth ("second growth") of current confinement and index guiding layers.

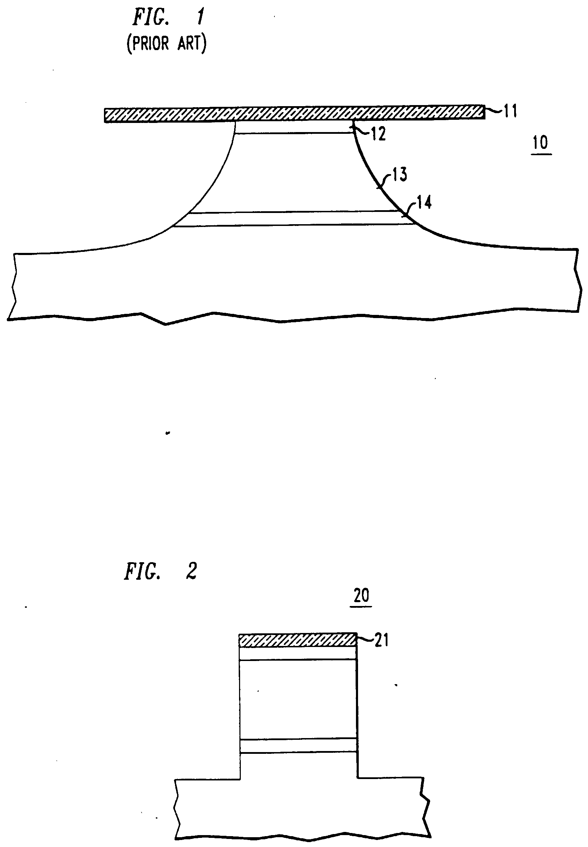

The conventional process has made possible manufacture of high quality lasers. However, the conventional process typically has low yield, resulting in high cost of such lasers. A major reason for the low yield is the above mentioned wet etching step. FIG. 1 schematically depicts an exemplary prior art mesa 10 with SiO₂ mask stripe 11 thereon. Numerals 12-14 refer, respectively, to the cap layer, cladding layer and active layer of the structure. As can be seen, the mask considerably overhangs the mesa. This is found to be necessary to prevent the rapid, non-planar re-growth that occurs at the edge of the mask-InP interface if mask and mesa top are substantially of the same width. Because of this large overhang, loss of the mask stripe is common. Mesas without mask stripe generally are not suitable for further processing. Furthermore, the width of mesa 10 typically varies over the wafer, requiring selection of those portions whose width is within the specified limits.

GB-A-2253304 teaches that dry etching (i.e., reactive ion etching, RIE) can be used to define the mesa, provided the subsequent vapor deposition (typically metal organic chemical vapor deposition; MOCVD) involves an atmosphere that comprises a halogen-yielding species, exemplarily 1, 1, 1 trichlorethane (TCE). The invention of GB-A-2253304 is an important one since it results in a process that can have substantially higher device yield than the conventional process. However, we have found that frequently the characteristics of the thus produced lasers were somewhat inferior to those of the best analogous prior art (wet etched) lasers. In view of the importance of InP-based BH lasers, it would be desirable to have available a process that uses dry etching and vapor deposition, substantially as disclosed in GB-A-2253304, and yet yields lasers of improved quality, desirably of a quality comparable to that of the best analogous prior art lasers. This application discloses such a process.

### The Invention

The invention is as defined by the claims, and is embodied in a process of making InP-based BH lasers that can be used to produce, with relatively high yield, lasers having characteristics that are comparable to those of the best analogous prior art lasers.

### Brief Description of the Drawings

FIG. 1 schematically depicts a prior art mesa structure with the mask stripe thereon;
FIG. 2 shows schematically a RIE-produced mesa structure; and
FIGs. 3-5 show exemplary L-I data for, respectively prior art lasers, lasers with RIE-produced mesa that were made without and with the etching step according to the invention.

We currently believe that the observed somewhat inferior characteristics of many InP-based BH lasers that are produced by a process that involves formation of the mesa structure by RIE is related to the presence of ion bombardment damage in the near-surface region of the semiconductor material, especially in the mesa side walls, or possibly due to impurities that are transported to the semiconductor surface by the R.F. plasma. Thus, in a broad aspect the invention is embodied in a manufacturing process which involves mesa etching by means of RIE, and which presents for the "second growth" step semiconductor substrate material which is substantially free of ion bombardment damage or contamination. An approach according to the invention involves, subsequent to completion of RIE and prior to second growth, a light chemical etch that removes an operative amount of semiconductor material, typically at least 10 nm, exemplarily about 0.1µm.

By an "operative amount" we mean an amount (expressed as a layer thickness) whose removal results in substantial improvement (e.g., at least 10%) in the average value of at least one device characteristic (e.g., the laser threshold current at room temperature) as compared to the average value of the same characteristic in otherwise identical lasers which were not given the light chemical etch according to the invention.

The average value of a device characteristic advantageously is the average value over a sample of at least about 10 devices.

More specifically, the invention preferably involves a method of making an article that comprises an InP-based BH laser that comprises providing a multilayer semiconductor body (typically a wafer) that comprises InP, forming on the surface of the body a patterned mask layer, and exposing the surface with the patterned mask layer thereon to ion bombardment from a gaseous etching medium such that at least one mesa-like structure is formed on the surface. Significantly, the method also comprises contacting the surface with the mesa structure thereon with a liquid etching medium such that an operative amount of semiconductor material is removed from the surface prior to growing In- and P-containing III/V semiconductor material on the surface. The growth process comprises contacting the surface with a gas that comprises an indium-containing organic composition, a source of phosphorus, and a further organic composition that contains halogen (typically Cl). The process typically also comprises conventional cleaning steps between RIE and second growth. These optional conventional cleaning treatments are known to remove at most insignificant amounts of semiconductor material.

"Second growth" conditions can be as described in GB-A-2253304. Subsequent process steps can be conventional and do not require detailed description. However, we have found it to be at times advantageous to grow, prior to exposing the wafer to Cl, a thin (e.g., about 0.1µm) layer of InP.

FIG. 2 schematically depicts a RIE-produced mesa (20) according to the invention, with mask stripe 21 having substantially the same width as the mesa.

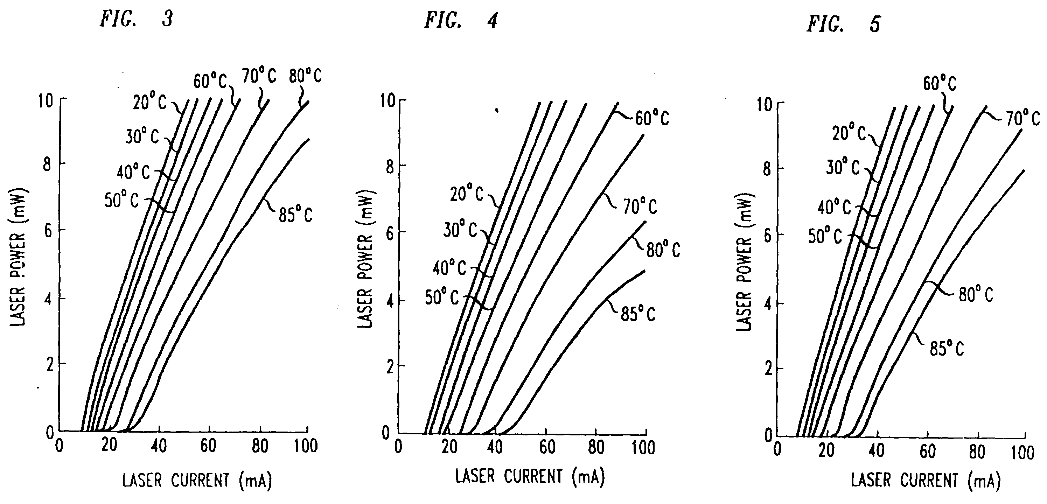

FIGs. 3-5 show data on laser current vs. laser power, for temperatures from 20-85°C, for prior art (wet etched), RIE only, and RIE plus an etch according to the invention, InP-based BH lasers, respectively. The improvement in going from "RIE only" to "RIE plus etching" is evident from FIGs. 4 and 5. The figures show that lasers produced according to the invention have threshold current that is substantially like that of the wet etched lasers, and is more than 10% better than that of the "RIE only" lasers. The figures also show that the lasers according to the invention have slope efficiency that is substantially like that of the wet etched (prior art) lasers, substantially higher than that of the "RIE only" lasers. Finally, the inventive process had substantially (more than 10%) higher yield than the prior art (wet etch) process. Except for the indicated differences in the process of making the lasers, (and the attendant structure and property differences), the lasers of FIGs. 3-5 were identical.

Example 1. In a commercially available low pressure MOCVD reactor, the following layer structure was grown on an InP wafer, substantially as described by D. Coblentz et al., Applied Physics Letters, Vol. 59, p. 405. A n-InP buffer layer; a graded (1.1µm to 1.15µm) GaInAsP layer; an active region consisting of 10 strained quantum wells (1.36µm GaInAsP, each 6 nm thick), with 6 nm thick 1.15µm GaInAsP barrier layers therebetween; a 0.7µm thick confinement layer of p-InP; and a 0.2µm thick layer of 1.15µm GaInAsP. Those skilled in the art are familiar with the nomenclature of specifying a quarternary III/V composition by means of the corresponding bandgap energy (expressed as the corresponding wavelength).

On the thus produced multilayer structure was deposited a 300 nm SiO₂ mask layer by conventional means, followed by conventional lithography that resulted in 2µm wide mask stripes. Laser mesas were etched using a CH₄/H₂ RIE process, with 0.6W/cm² power density, 13.3 Pa (100 mTorr) pressure, and 15% CH₄ concentration, with -5200 volt DC bias giving an etch rate of about 40 nm/min. The RIE resulted in about 1.4µm wide mesas, substantially as shown schematically in FIG. 2.

Following RIE, the wafer was exposed in conventional manner to an O₂ plasma [100 Watt, 1 hour 6.67 Pa (50 mTorr)] for hydrocarbon removal, followed by 3 minutes in concentrated H₂SO₄. These two treatments are conventional and are known to remove at most an insignificant amount of semiconductor material. Any remaining oxide was removed by a conventional 10 seconds etch in 10% HF: 90% H₂O. These conventional steps were followed by the novel damage removal step, namely a 30 second etch in 8 HBr:2H₂O₂ (30%):90 H₂O. The latter etch isotropically removed somewhat less than 100 nm of semiconductor material, sufficient to remove substantially all of the damaged semiconductor material. Those skilled in the art will appreciate that the recited conditions are exemplary only, and also that there are likely to be other etchants which could also be used to remove the damaged semiconductor material.

After an additional conventional cleaning step (3 minutes in concentrated H₂SO₄; H₂O rinse) the wafer was transferred into a conventional atmospheric pressure growth reactor for the second growth (growth of blocking layers around the mesa). Blocking layer growth was conventional, except that it was found advantageous to equilibrate the gas flow for a substantial period prior to growth, and to grow a minor amount (e.g., less than about 200 nm) of semi-insulating InP before adding the chlorine-bearing compound to the gas stream.

Specifically, the growth chamber was flushed with H₂ (5000 sccm) for 400 seconds, followed by flushing (to vent) trichloroethane (TCE) at 2 sccm. The TCE was derived from a liquid source at -10°C. After 30 minutes, 120 sccm PH₃ in H₂ (20:80) were added to the gas flow and the sample temperature raised to 600°C. After reaching that temperature, 120 nm of semi-insulating InP (70 sccm trimethyl indium, 3 sccm ferrocene) were grown in 120 seconds. At this point the 2 sccm TCE were switched from vent to the gas stream and growth continued for 50 minutes, resulting in 3µm semi-insulating InP with planar growth. After cooling under PH₃ and H₂, the chamber was flushed with N₂ and the sample removed.

After conventional removal of the SiO₂ mask stripe in HF and of the quarternary (1.15µm) cap by etching in 4H₂SO₄: 1 H₂O₂ (30%): 1 H₂O (48°C, 15 seconds) and rinse, the sample was re-inserted in the growth chamber for conventional "third" (cap) growth. The cap was grown at 600°C and consists of 1.3µm p-type InP, with doping level starting at 5 × 10¹⁷/cm³, increasing to 2 × 10¹⁸/cm³; 0.12µm InGaAs doped at 5 × 10¹⁸/cm³; and 0.06µm InGaAs doped at 2 × 10¹⁹/cm³. After cool-down under PH₃+H₂, the sample was metallized, cleaned and tested in conventional fashion. The yield of acceptable lasers was substantially greater than those from an analogous prior art waver. The average (more than 10 samples) L-I characteristics of the lasers were substantially as shown in FIG. 5.

## Claims

1. A method of making an article that comprises a buried heterojunction laser that comprises InP, the method comprising
a) providing a multilayer semiconductor body that comprises InP, said body having a major surface;
b) forming on said surface a patterned mask layer (21);
c) exposing the surface with the patterned mask layer thereon to ion bombardment from a gaseous etching medium, such that at least one mesa-like structure (20) is formed on the surface; and
d) growing In- and P-containing III/V semiconductor material on the surface; whereby
said In- and P-containing semiconductor material is grown by a vapor deposition process that comprises contacting the surface with a deposition gas that comprises an indium-containing organic composition, a source of phosphorus, and a further organic composition that contains halogen; the method being CHARACTERIZED by
e) contacting, subsequent to step c) and prior to step d), said surface with the mesa-like structures thereon with a liquid etching medium such that at least 10 nm of semiconductor material is removed from said surface.

2. Method according to claim 1, wherein said liquid etching medium comprises HBr and H₂O₂.

3. Method of claim 2, wherein said liquid etching medium has the composition 8HBr:2H₂O₂ (30%):90H₂O.

## Patentansprüche

1. Verfahren zur Herstellung eines Gegenstandes, der einen vergrabenen Heteroübergangs-Laser, der InP umfaßt, enthält, wobei das Verfahren umfaßt:
a) Bereitstellen eines Mehrlagenhalbleiterkörpers, der InP umfaßt, wobei der Körper eine Hauptoberfläche hat,
b) Ausbilden einer strukturierten Maskenschicht (21) an der Oberfläche,
c) Einwirkenlassen eines Ionenbeschusses aus einem gasförmigen Ätzmedium auf die Oberfläche mit der strukturierten Maskenschicht an dieser derart, daß wenigstens eine Mesa-artige Struktur (20) an der Oberfläche ausgebildet wird, und
d) Aufwachsen von In- und P-enthaltendem III/V Halbleitermaterial an der Oberfläche, wobei das In- und P-enthaltende Halbleitermaterial durch einen Gasphasenabscheidungsprozeß aufgewachsen wird, welcher das in Kontakt treten der Oberfläche mit einem Abscheidungsgas, das eine Indium-enthaltende organische Zusammensetzung, eine Quelle von Phosphor und eine weitere organische Zusammensetzung, die ein Halogen enthält, umfaßt und das Verfahren
gekennzeichnet ist durch
e) in Kontakt treten lassen nach dem Schritt c) und vor dem Schritt d) der Oberfläche mit den Mesa-artigen Anordnungen daran mit einem flüssigen Ätzmedium derart, daß wenigstens 10 nm vom Halbleitermaterial von der Oberfläche entfernt wird.

2. Verfahren nach Anspruch 1, bei welchem das flüssige Ätzmedium HBr und H₂O₂ umfaßt.

3. Verfahren nach Anspruch 2, bei welchem das flüssige Ätzmedium die Zusammensetzung 8HBr:2H₂O₂(30%) :90H₂O umfaßt.

## Revendications

1. Procédé de fabrication d'un article comprenant un laser à hétérojonction enterrée, qui comprend de l'InP, le procédé consistant :
a) prendre un corps de semi-conducteur multicouche qui comprend de l'InP, ledit corps ayant une surface principale ;
b) à former sur cette surface une couche de masquage à motifs (21) ;
c) à exposer la surface, surmontée de la couche de masquage à motifs à un bombardement d'ions à partir d'un milieu de gravure gazeux, de façon qu'il se forme sur la surface au moins une structure (20) de type mésa ; et
d) à faire croître un matériau semi-conducteur III/V contenant In et P sur la surface, de façon que ledit matériau semi-conducteur contenant In et P croisse sous l'effet d'un procédé par déposition en phase vapeur qui consiste à mettre en contact la surface avec un gaz de déposition qui comprend une composition organique contenant de l'indium, une source de phosphore et une autre composition organique contenant un halogène,
caractérisé en ce qu'il consiste
e) à mettre en contact, après l'étape c) et avant l'étape d), ladite surface surmontée des structures de type mésa avec un milieu liquide de gravure tel qu'au moins 10 nm du matériau semi-conducteur soient enlevés de ladite surface.

2. Procédé selon la revendication 1, dans lequel ledit milieu liquide de gravure comprend HBr et H₂O₂.

3. Procédé selon la revendication 2, dans lequel ledit milieu liquide de gravure a la composition 8HBr:2H₂O₂ (30 %):90H₂O
